# EUROPEAN PATENT APPLICATION

(11) **EP 2 287 898 A2**
(43) Date of publication of application: **23.02.2011**
(21) Application number: 09173641.3
(22) Date of filing: 21.10.2009
(51) Int. Cl.: H01L 21/56, H01L 23/31

(54) **Shrink Package on Board**

(30) Priority: 20.10.2008 US 106618 P
(71) Applicant: United Test and Assembly Center, 554916 Singapore (SG)
(72) Inventor: Eng, Kian Teng, 545075 Singapore (SG); Manalac, Rodel, 730509 Singapore (SG); Park, Teck Wah, 521253 Singapore (SG); Gan, Richard Te, 530966 Singapore (SG)
(74) Representative: Maggs, Michael Norman

(57) **Abstract**

A method of forming a device is disclosed. The method includes providing a printed circuit board substrate having a die attach region on a first surface of the substrate. The method also includes attaching a die to a die attach region. The die is electrically coupled to first land pads disposed on the first surface at the periphery of the die attach region. A cap is formed in a target area by a top gate process to produce a cap with an even surface. The cap covers the die and leaves at least the first land pads exposed.

## Description

### CROSS-REFERENCE TO RELATED APPLICATIONS

This application claims the benefit of U.S. provisional application No. 61/106,618, filed October 20, 2008, the entire content of which is herein incorporated by reference.

### BACKGROUND

Chip-on-board (COB) packages typically have a die that is directly mounted on and electrically connected to a substrate that is made of printed circuit board material. When compared to quad flat no leads (QFN) packages, the PCB substrate would have a lower cost than the Copper/Allow 42 lead frame substrate of the QFN.

The COB package is encapsulated with a glob top material to protect the die and wire bonds from the environment. To encapsulate a COB package, a glob top dispensing process is employed. For example, the glob top material is dispensed as a glob over the package. The glob top material covers the die and wiring interconnections.

The glob top material, however, affects reliability of the COB package due to its low filler content. The glob top dispensing process involves dispensing the material unit by unit which is not efficient. The glob top dispensing process also results in a package having a curved or non-flat surface.

Conventional COB packages do not provide for testing as a package on board level due to the non-availability of external land pads for connection to a testing device after the COB package is mounted onto a board.

From the foregoing discussion, improved package and packaging techniques are desired.

### SUMMARY

A method of forming a device is disclosed. The method includes providing a printed circuit board substrate having a die attach region on a first surface of the substrate. The method also includes attaching a die to the die attach region. The die is electrically coupled to first land pads disposed on the first surface at the periphery of the die attach region. A cap is formed in a target area by a top gate process to produce a cap with an even surface. The cap covers the die and leaves at least the first land pads exposed.

In another embodiment, a device is presented. The device includes a printed circuit board substrate having a die attach region on a first surface of the substrate. A die is disposed in the die attach region. The die is electrically coupled to first land pads disposed on the first surface at the periphery of the die attach region. The device also includes a cap formed in a target area by a top gate process to produce a cap with an even surface. The cap covers the die and leaves the top land pads exposed.

In yet another embodiment, a method of forming a device is disclosed. The method includes providing a substrate having a die attach region on a first surface of the substrate. The method also includes disposing first land pads on the first surface at the periphery of the die attach region. When a die is attached to the die attach region, it is electrically coupled to the first land pads. A cap is formed in a target area by a top gate process when a die is attached to the die attach region. Forming the cap produces a cap with an even surface. The cap covers the die and leaves at least the first land pads exposed.

These and other objects, along with advantages and features of the present invention herein disclosed, will become apparent through reference to the following description and the accompanying drawings. Furthermore, it is to be understood that the features of the various embodiments described herein are not mutually exclusive and can exist in various combinations and permutations.

### BRIEF DESCRIPTION OF THE DRAWINGS

In the drawings, like reference characters generally refer to the same parts throughout the different views. Also, the drawings are not necessarily to scale, emphasis instead generally being placed upon illustrating the principles of the invention. In the following description, various embodiments of the present invention are described with reference to the following drawings, in which:

Figs. 1a-b and Figs. 2a-b show cross-sectional and top views of various embodiments of a package;

Fig. 2c shows a flip chip;

Figs. 3a-b and Figs. 4a-b show cross-sectional and top views of various embodiments of a package;

Fig. 4c shows another embodiment of a substrate;

Figs. 5-6 show other embodiments of a package; and

Figs. 7a-c show a process of forming a package.

### DETAILED DESCRIPTION

Embodiments generally relate to semiconductor packages for chips or ICs. Various types of chips or ICs can be packaged. For example, the IC can be a memory device such as a dynamic random access memory (DRAM), a static random access memory (SRAM) and various types of non-volatile memories including programmable read-only memories (PROM) and flash memories, an optoelectronic device, a logic device, a communication device, a digital signal processor (DSP), a microcontroller, a system-on-chip, as well as other types of devices. The ICs can be incorporated into various products, such as phones, computers, personal digital assistants or other types of suitable products.

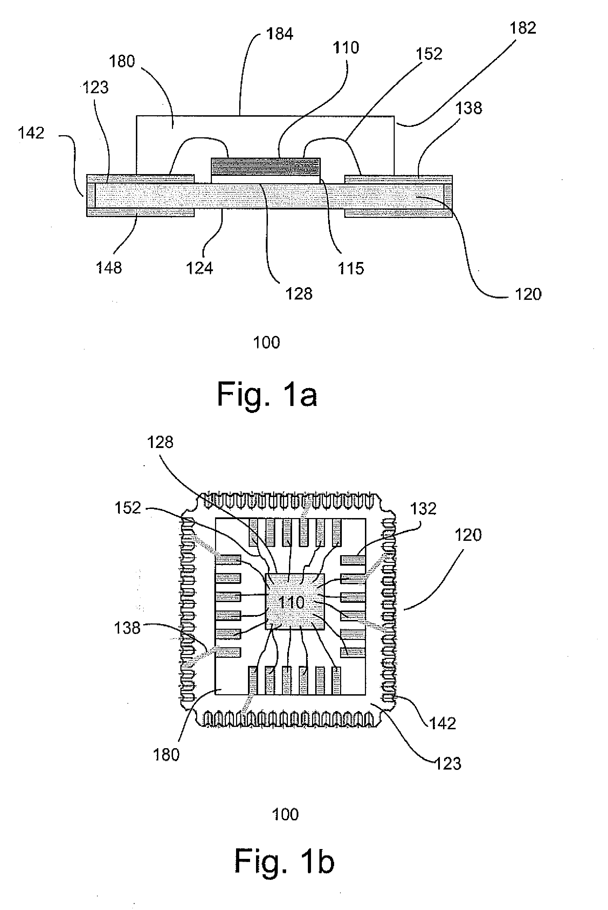

Figs. 1a-b show cross-sectional and top views of an embodiment of a package 100. The package includes a substrate 120 with top and bottom major surfaces 123 and 124. Typically, the substrate comprises a rectangular shape to form a rectangular shaped device. Other shapes are also useful. The substrate may be a single layer substrate or a multi-layer substrate. For a multi-layer substrate, the different layers can be laminated or built-up. Various materials can be used to form the substrate.

In one embodiment, the substrate comprises a printed circuit board (PCB) substrate. The PCB substrate, for example, comprises FR-4 or FR-5. Other types of PCB materials are also useful. Alternatively, other types of substrates may be used. The top major surface includes a die attach region 128. Bonding fingers 132 are disposed in the periphery of the die attach region. For example, the bonding fingers are arranged to surround the die attach region. The bonding fingers, for example, comprise copper. Other types of conductive material may also be useful. The bonding fingers may be coated with nickel, gold, silver, or combinations thereof, to improve bondability of the wire bonds to be formed thereon. The bonding fingers may also be coated with an anti-oxidizing material such as an organic solderability preservative (OSP). Other types of anti-oxidizing materials may also be useful.

In one embodiment, top land pads are formed along the top periphery of the substrate; bottom land pads are formed along the bottom periphery of the substrate. In one embodiment, castellation leads 142 are disposed on the sides of the substrate. The castellation leads extend from the top surface to the bottom surface of the substrate to electrically couple the top land pads to the bottom land pads. The castellation leads can be formed from a conductive material. In one embodiment, the castellation leads comprise copper. Other types of conductive materials may also be used.

Top conductive traces 138 are disposed on the top surface of the substrate. The top conductive traces electrically couple the bonding fingers to the top land pads. For example, top conductive traces electrically couple the bonding fingers to respective top land pads. The conductive traces can be formed from a conductive material. In one embodiment, the conductive traces comprise copper. The use of other types of conductive materials may also be useful. The conductive traces may be coated with an insulating material, for example, solder mask.

On the bottom surface of the substrate, the bottom land pads are formed along the periphery of the substrate. The bottom land pads function as external connections of the package to electrically couple the package to an external device. On the top surface of the substrate, the top land pads are formed along the periphery of the substrate. The top land pads provide access to testing devices, particularly when the package is mounted onto a board, to verify the electrical connection between the wires and the die. The package can be mounted onto a board by soldering the bottom land pads to the board. Another function of the top and bottom land pads and castellation leads is to enable the package to be mounted onto the board by clipping connection.

A semiconductor die 110 is provided. The semiconductor die comprises active and inactive major surfaces. The active surface, for example, includes bond pads to provide access to the internal circuitry of the die. In one embodiment, the inactive surface is mounted onto the die attach region of the substrate. In one embodiment, the die is attached using an adhesive 115. The adhesive can be, for example, an epoxy. Examples of adhesive epoxies include Ablestik 2025D and Yiztech N7728. Other types of adhesives, including tape, may also be useful.

In one embodiment, wire bonds 152 are provided. The wire bonds electrically couple the bonding fingers to the bond pads on the die. For example, the wire bonds electrically couple the bonding fingers to respective bond pads on the die. The wire bonds 152 preferably comprise copper wires. The use of copper wires can facilitate the use of smaller bond pads, for example, below 50 um x 50 um. Other types of conductive wires, such as gold wires or aluminum wires, may also be useful.

A cap 180 is provided for the package. The cap, in one embodiment, encapsulates the semiconductor die 110 and the wire bonds 152. The cap, for example, comprises a mold compound. Various types of mold compounds, such as epoxy, may be used. As shown, the cap covers the bonding fingers where the wire bonds are disposed. Leaving the top landing pads exposed enables testing of the package to be easily performed when it is mounted on board. If testing is not required to be performed, the cap may cover the entire top surface of the substrate.

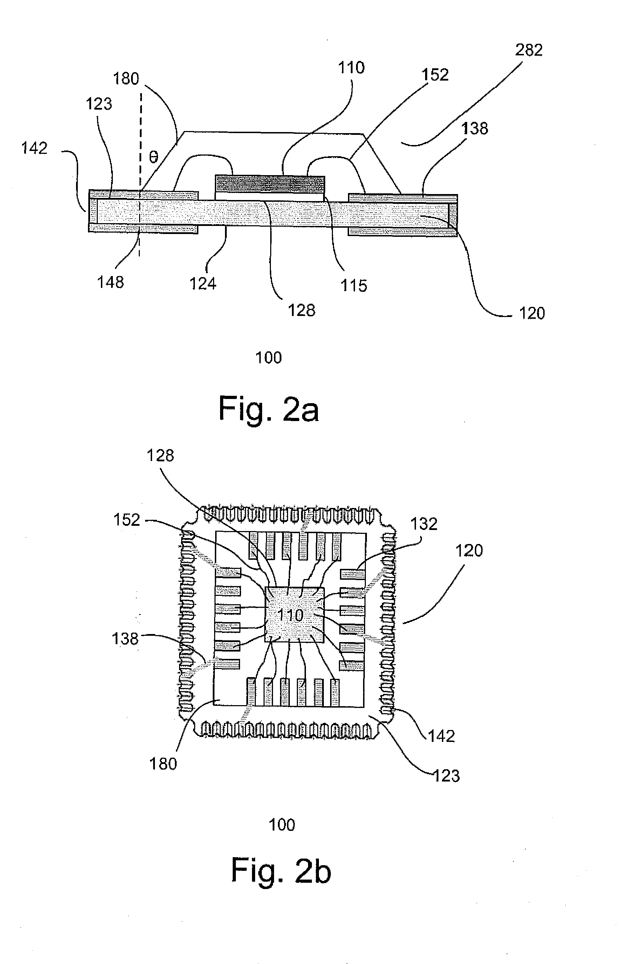

In accordance with one embodiment, the cap comprises a flat or even surface 184. As shown, the cap includes sidewalls 182 which are about perpendicular to the top surface of the cap. For example, the sidewalls are vertical with respect to the horizontal top surface of the cap. Alternatively, as shown in Figs. 2a-b, the sidewalls 282 of the cap are sloped or slanted. The angle θ of the sidewalls, for example, is about 15 - 45°. Other sidewall angles may also be useful. Providing an even surface facilitates marking of the package.

The cap, in accordance with one embodiment, is provided without damaging the package. For example, the cap is formed by a top gate molding process whereby the mold compound is injected from the top of the mold instead of a side gate. If the mold compound is injected by a side gate molding process, the mold compound would flow beyond the target area. For example, the mold compound would flow over the conductive traces and top land pads, which can damage these components.

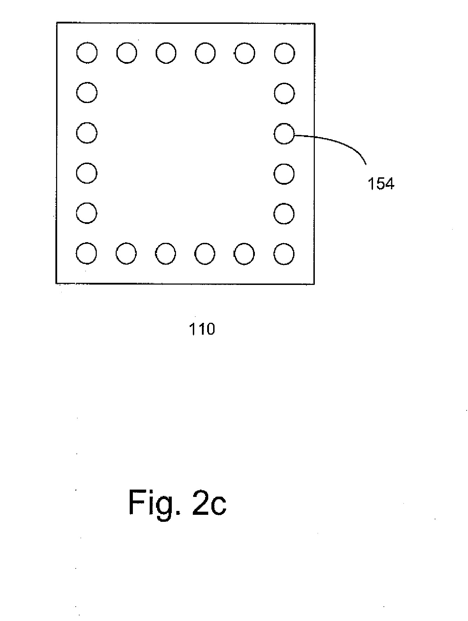

In other embodiments, the die 110 may comprise a flip chip, as shown in Fig. 2c. The flip chip, for example, comprises die bumps 154 disposed on an active surface. As shown, the die bumps are disposed near the periphery of the die. Other die bump configurations are also useful. The die bumps are coupled to respective contact pads disposed on the substrate in the die region. Electrical traces may be provided to electrically couple the contact pads to land pads on the surface of the substrate.

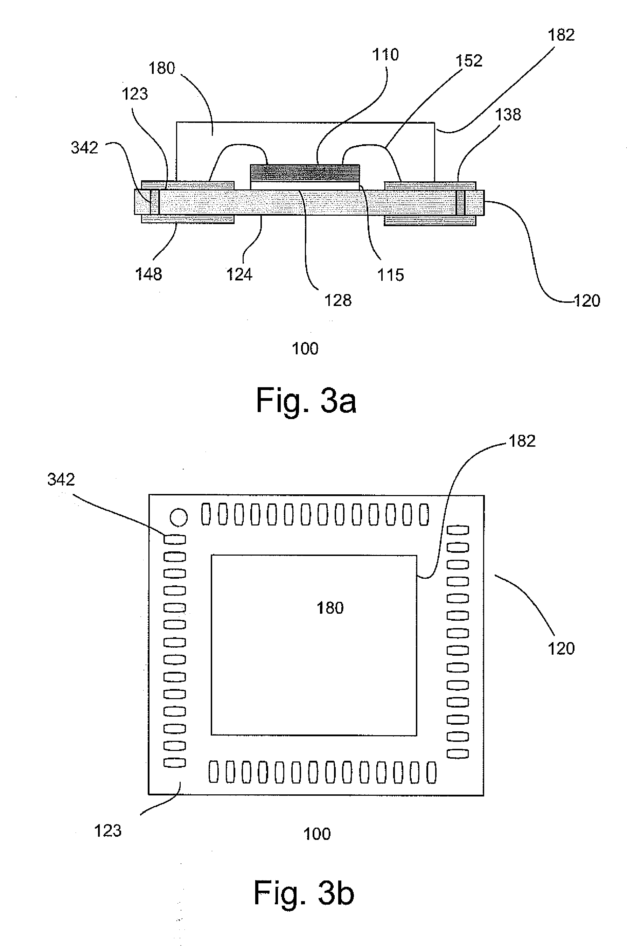

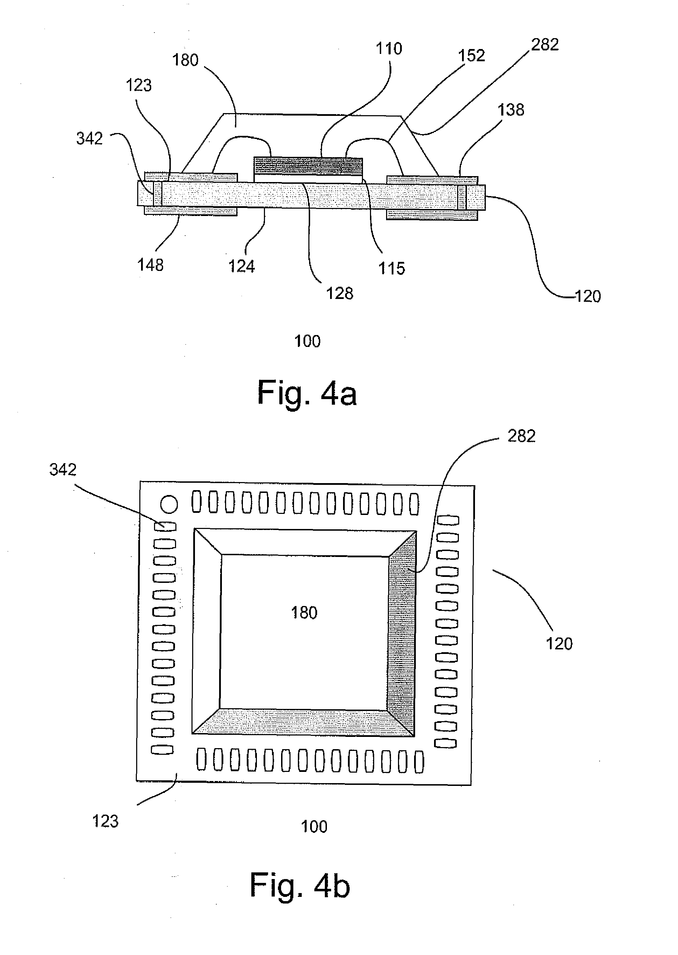

Figs. 3a-b and Figs. 4a-b show cross-sectional and top views of other embodiments of a package 100. The packages are similar to the packages as described in Figs. 1a-b and Figs. 2a-b with the exception of the substrate 120. In one embodiment, the substrate comprises through vias 342 instead of castellation leads. The through vias are disposed within the substrate and extend through the top and bottom surfaces 123 and 124. The through vias, for example, are disposed near the periphery of the substrate. In one embodiment, the through vias are arranged around about the periphery of the substrate. The through vias electrically couple the top and bottom land pads.

Referring to Figs. 3a-b, the cap 180 includes an even top surface with perpendicular sidewalls 182. Alternatively, the cap 180 may include sloping sidewalls 282, as illustrated in Figs. 4a-b.

In other embodiments, the land pads can be arranged as a single row of land pads or multiple rows of land pads. For example, a substrate 120 can have land pads arranged in first and second (dual) rows. The land pads, for example, are disposed on the periphery of the substrate. Configuring the land pads in other number of rows is also useful. In one embodiment, the land pads are coupled to bonding fingers 132 disposed around the die attach region. The bonding fingers are electrically coupled to a die. The bonding fingers are arranged in a single row of bonding fingers. Configuring the bonding fingers in other number of rows is also useful. Conductive traces 138 couple the top land pads to the bonding fingers.

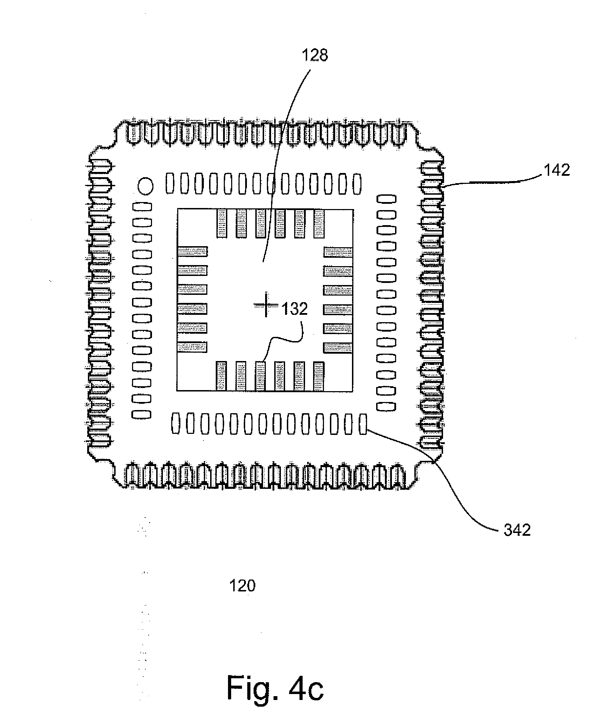

In one embodiment, the land pads are coupled to through vias which are coupled to bottom land pads. Coupling land pads to castellation leads is also useful. In another embodiment, as shown in Fig. 4c, the substrate 120 can include land pads surrounding the die attach region 128. The land pads are coupled to bonding fingers by, for example, conductive traces. The land pads are coupled to through vias 342 and castellation leads 142. For example, one row of land pads can be coupled to the through vias while the other row of land pads are coupled to castellation leads. In one embodiment, land pads of the first row closest to the die attach region are coupled to the through vias while the land pads of the second row are coupled to the castellation leads. In other embodiments, the number of rows of land pads on opposing sides of the substrate may not be the same. For example, the top surface of the substrate may have single row land pads at the periphery while the bottom surface of the substrate may have dual rows land pads at the periphery. Other configurations of land pads, through vias, castellation leads and or bonding fingers are also useful.

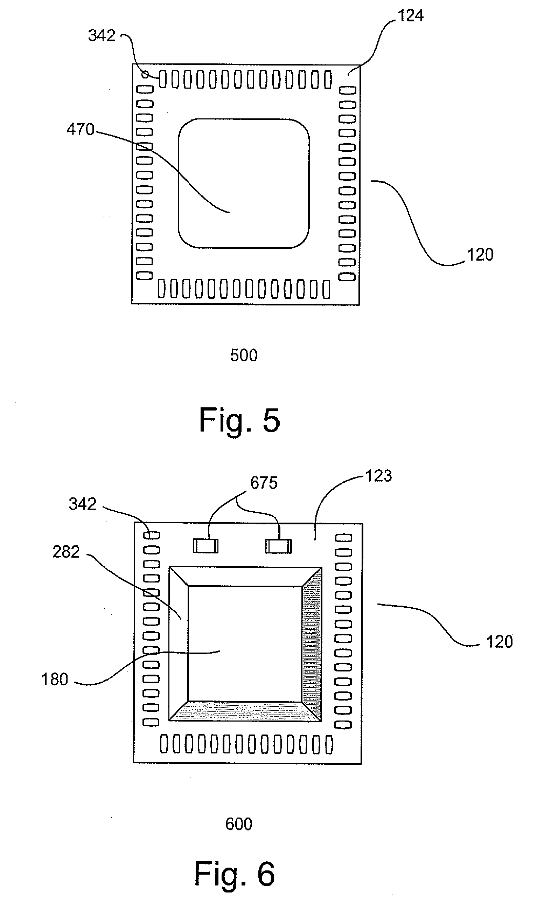

Fig. 5 shows another embodiment of a package 500. The package includes a substrate 120. As shown, the substrate comprises a plurality of through vias 342 disposed, for example, at about the periphery of the substrate. The through vias extend from the top surface to the bottom surface 124 of the substrate. In one embodiment, the through vias are arranged around about the periphery of the substrate. In another embodiment, castellation leads instead of through vias can be provided at the sides of the substrate. In yet another embodiment, the substrate may include a combination of castellation leads and through vias. Top conductive traces on the top surface provide interconnection from the external land pads to the internal circuitry of the die, as already described.

The die may be connected to the bonding fingers by wire bonds. The die and wire bonds may be encapsulated by a cap, protecting them from the environment. In other embodiments, the die may comprise a flip chip connected to substrate pads on the substrate via die bumps on the die's active surface. For such applications, the die is encapsulated by a cap, protecting it from the environment. The cap, for example, comprises a planar top surface with perpendicular or sloped sidewalls.

In one embodiment, the bottom surface of the substrate includes a heat sink 470. The heat sink, for example, is disposed in an area on the bottom surface corresponding to the die attach region on the top surface. The area which the heat sink is disposed is devoid of external contacts. In one embodiment, the heat sink comprises a heat dissipating material, such as copper. Other types of heat dissipating or heat conductive materials are also useful. The heat sink, for example, enables heat dissipation from the die to an external surface mount technology (SMT) module.

Fig. 6 shows yet another embodiment of a package 600. The package includes a substrate 120 with a plurality of through vias 342 disposed, for example, at about the periphery of the substrate. The through vias extend from the top surface 123 to the bottom surface of the substrate. In one embodiment, the through vias are arranged around about the periphery of the substrate. In other embodiment, castellation leads instead of through vias can be provided at the sides of the substrate. In yet another embodiment, the substrate may include a combination of castellation leads and through vias. Top conductive traces on the top surface provide interconnection from the external land pads to the internal circuitry of the die, as already described.

The die may be connected to the bonding fingers by wire bonds. The die and wire bonds may be encapsulated by a cap, protecting them from the environment. In other embodiments, the die may comprise a flip chip connected to substrate pads on the substrate via die bumps on the die's active surface. For such applications, the die is encapsulated by a cap, protecting it from the environment. The cap, as shown, comprises a planar top surface with sloped sidewalls 282. Alternatively, the cap may be provided with a planar top surface with perpendicular sidewalls.

In one embodiment, the top surface of the substrate is provided with at least one passive component 675. As shown, the top surface is provided with two passive components. Providing the package with other number of passive components is also useful. The passive components, for example, can be resistors, capacitors or a combination thereof. The passive components can be selected to enhance the electrical performance of the package. The passive components, as shown, are disposed outside the cap. Providing the passive components within the cap or a combination of inside and outside the cap is also useful.

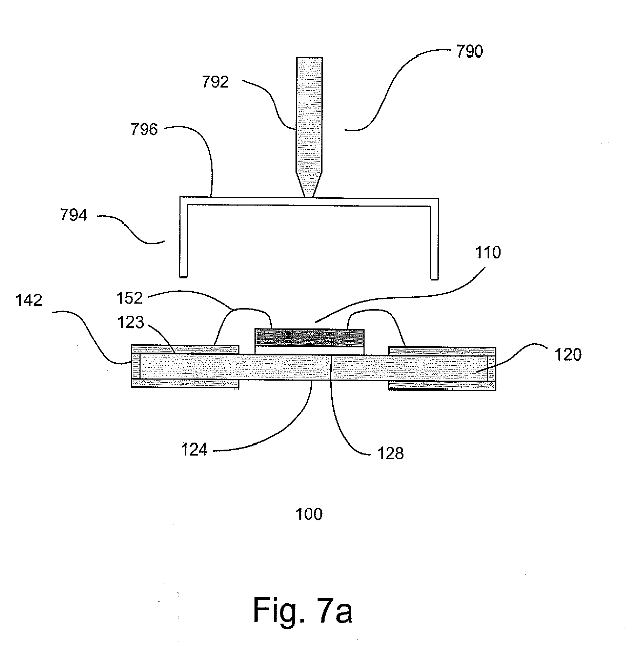

Figs. 7a-c show an embodiment of a process of encapsulating a package. Referring to Fig. 7a, a package 100 is provided. The package includes a substrate 120 with top and bottom surfaces 123 and 124. The substrate, in one embodiment, comprises a PCB. Other types of substrates may also be useful. A die 110 is attached to a die attach region 128 defined on the top surface 123. The die is mounted to the die attach region using, for example, an adhesive. Wire bonds 152 electrically coupled die bond pads to bonding fingers on the top surface of the substrate. Top conductive traces on the top surface provide interconnection from the external land pads to the bonding fingers and, in turn, to the internal circuitry of the die.

In other embodiments, the package may include a die having die bumps which are mated to substrate pads on the die attach region. In yet other embodiments, the package may include a heat sink on the bottom surface of the substrate and/or passive components on the top surface of the substrate. Other types of packages may also be useful.

The package is disposed in a mold compound injection system. The injection system comprises an injection unit 790. The injection unit, in one embodiment, comprises an injector 792 coupled to a mold 794. The mold comprises a desired shape of the cap. For example, as shown, the mold comprises a rectangular shaped mold having a planar top surface and perpendicular side surfaces. Such a shape produces a cap having a planar top surface and perpendicular sidewalls. Other shaped molds are also useful. For example, the side surfaces may be sloped with respect to the planar surface.

In accordance to one embodiment, the injector is coupled to a top surface 796 of the mold. For example, the injection is coupled to about a center of the top surface of the mold. Coupling the injector at other locations at the top surface of the mold may also be useful. Coupling the injector at the top surface of the mold produces a top gate injection unit.

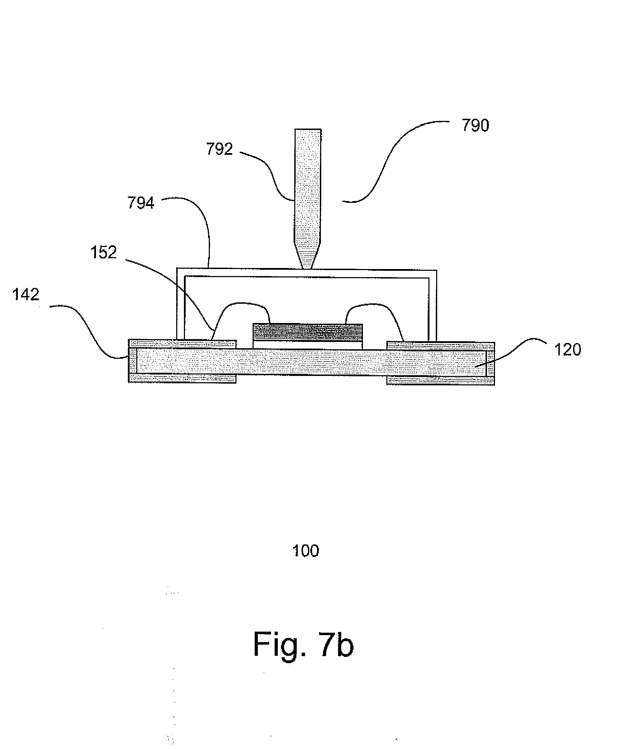

Referring to Fig. 7b, the injection unit is lowered into position onto the package. For example, the injection is lowered such that the mold covers the die and wire bonds and not the land pads. When in position, the injection unit is activated to cause the injector to inject a mold compound into the mold.

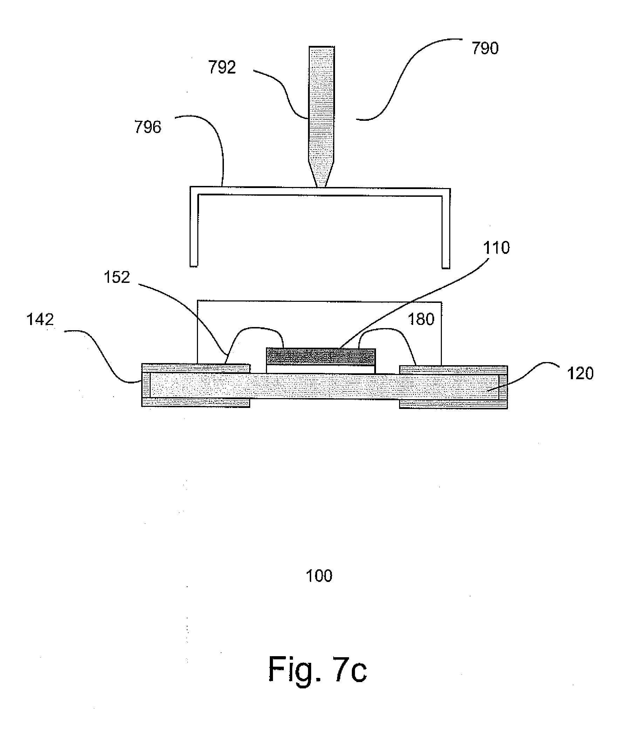

In Fig. 7c, the process continues. For example, after the mold compound has solidified sufficiently through cooling, the injection unit is raised. The mold compound forms a cap over the die and wire bonds, completing the encapsulation process.

The encapsulation process may be performed in parallel. For example, a plurality of packages may be encapsulated at one time. This may be achieved by providing a carrier substrate or PCB having a plurality of dies assembled thereto. The injection unit encapsulates the plurality of dies at one time. Thereafter, the carrier substrate is processed to singulate it into individual packages. The singulation can be achieved by, for example, sawing or punch singulation.

As described, the die is encapsulated using a modified mode design. In one embodiment, the die is encapsulated using a top gate molding process. Top gate molding process provides several advantages. For example, the top gate molding process results in a flat top surface of the encapsulation body, thereby enabling ink marking to be carried out without distortion. Another advantage is that top gate molding results in higher and more reliable throughput than conventional liquid encapsulation techniques for COB packages, such as Glob Top Dispensing and Printing/Vacuum Printing Encapsulation. For example, top gate molding can be encapsulated multiple dies on a carrier substrate strip in parallel while gob top dispensing encapsulates one die at a time.

Additionally, higher package reliability and performance can be achieved with the mold compound than liquid encapsulation material. For example, transfer molding with mold compound achieves excellent thickness control of the cap, and reduced array warpage due to lower shrinkage of the molding compound, as well as lower water absorption.

Furthermore, the lower CTE characteristics of the molding compound enables the package to integrate easily with copper wire bonding which can offer a potentially smaller package footprint, cost reduction solution and higher reliability performance as compared to the current COB packaging technologies. Moreover, by implementing copper wire bonding, the present packaging process can overcome challenges of fine pitch bonding and also result in lower assembly cost. By using the PCB board instead of Copper/Alloy 42 leadframe, this will significantly reduce the tooling cost and lead-time required. In addition, there will also be savings in the raw materials. The present package can be saw or punch singulated, imparting additional flexibility.

The invention may be embodied in other specific forms without departing from the spirit or essential characteristics thereof. The foregoing embodiments, therefore, are to be considered in all respects illustrative rather than limiting the invention described herein. Scope of the invention is thus indicated by the appended claims, rather than by the foregoing description, and all changes that come within the meaning and range of equivalency of the claims are intended to be embraced therein.

What is claimed is:

## Claims

1. A method of forming a device comprising:
providing a printed circuit board substrate having a die attach region on a first surface thereof;
attaching a die to the die attach region, wherein the die is electrically coupled to first land pads disposed on the first surface at the periphery of the die attach region; and
forming a cap in a target area by a top gate process to produce a cap with an even surface, wherein the cap covers the die and leaves at least the first land pads exposed.

2. The method of claim 1 wherein the die is electrically coupled to bonding fingers by wire bonds, the bonding fingers are coupled to the first land pads.

3. The method of claim 2 wherein the cap covers bond wires and a portion of the bonding fingers.

4. The method of claim 3 wherein the top gate process avoids flowing of cap material outside of the target area which can damage the package.

5. The method of claim 1 wherein the die comprises a flip chip.

6. The method of claim 5 wherein the top gate process avoids flowing of cap material outside of the target area which can damage the package.

7. The method of claim 1 wherein the top gate process avoids flowing of cap material outside of the target area which can damage the package.

8. The method of claim 1 wherein:
the first land pads are coupled to castellation leads disposed on the edges of the substrate; and
the castellation leads extend through first and second surfaces of the substrate, the castellation leads are coupled to external contacts disposed on the second surface of the substrate.

9. The method of claim 1 wherein:
the first land pads are electrically coupled to through vias which extend through first and second surfaces of the substrate; and
the through vias are coupled to external contacts disposed on the second surface of the substrate.

10. The method of claim 1 wherein:
first land pads are configured in at least first and second rows surrounding the die attach region; and
the first land pads are coupled to through vias or castellation leads.

11. The method of claim 10 wherein the first land pads are coupled to through vias and castellation leads.

12. The method of claim 10 wherein:
the land pads of the first row are to through vias; and
the land pads of the second row are coupled to castellation leads.

13. The method of claim 12 wherein the first row is closer to the die attach region than the second row.

14. The method of clam 1 wherein second land pads are disposed on the second surface of the substrate, the second land pads.

15. The method of clam 14 wherein second land pads serves as external contacts.

16. A device comprising:
a printed circuit board substrate having a die attach region on a first surface thereof;
a die disposed in the die attach region, wherein the die is electrically coupled to first land pads disposed on the first surface at the periphery of the die attach region; and
a cap formed in a target area by a top gate process to produce a cap with an even surface, wherein the cap covers the die and leaves the top land pads exposed.

17. The device of claim 16 wherein the gate process results in material of the cap contained in the target area to avoid damaging the device.

18. The device of claim 16 where the die comprises a flip chip die.

19. The device of claim 16 wherein the die is electrically coupled to the first land pads with wire bonds via bonding fingers.

20. A method of forming a device comprising:
providing a substrate having a die attach region on a first surface thereof;
disposing first land pads on the first surface at the periphery of the die attach region, wherein when a die is attached to the die attach region, it is electrically coupled to the first land pads; and
forming a cap in a target area by a top gate process when a die is attached to the die attach region, wherein forming the cap produces a cap with an even surface, wherein the cap covers the die and leaves at least the first land pads exposed.
